Europäisches Patentamt

European Patent Office

Office européen des brevets

(19)

(11) Publication number: **0 032 022**
B1

(12) **EUROPEAN PATENT SPECIFICATION**

(45) Date of publication of patent specification: 01.08.84

(21) Application number: 80304583.0

(22) Date of filing: 18.12.80

(51) Int. Cl.³: **H 01 L 21/265,** H 01 L 21/76, H 01 L 21/74

(54) A method of fabricating a semiconductor integrated circuit device.

(30) Priority: 21.12.79 JP 166596/79

(43) Date of publication of application:
15.07.81 Bulletin 81/28

(45) Publication of the grant of the patent:
01.08.84 Bulletin 84/31

(84) Designated Contracting States:
DE FR GB NL

(56) References cited:
JP - A - 53 087 672

NEWS AUS DER TECHNIK, vol. 1978, no. 3,
June 15, 1978, Würzburg, DE, "Herstellung
bipolarer integrierter Schaltungen ohne
Epitaxie", abstract 465
IBM TECHNICAL DISCLOSURE BULLETIN, vol.
19, no. 11, April 1977, New York, US, A.E.
MICHEL et al. "Bipolar integrated circuits
without epitaxial layers", page 4151
IBM TECHNICAL DISCLOSURE BULLETIN, vol.
14, no. 5, October 1971, New York, US J.E.
ZIEGLER et al. "Self-isolating bathtub collector
for a planar transistor", pages 1635-1636

(73) Proprietor: FUJITSU LIMITED
1015, Kamikodanaka Nakahara-ku
Kawasaki-shi Kanagawa 211 (JP)

(72) Inventor: Sakurai, Junji
7-11, Seta 4-chome Setagaya-ku
Tokyo 158 (JP)
Inventor: Kamioka, Hajime
370-40, Kamikashio-cho Totsuka-ku
Yokohama-shi Kanagawa 244 (JP)

(74) Representative: Sunderland, James Harry et al,
HASELTINE LAKE & CO Hazlitt House 28
Southampton Buildings Chancery Lane
London WC2A 1AT (GB)

## Description

The present invention relates to a method of fabricating a semiconductor integrated circuit device.

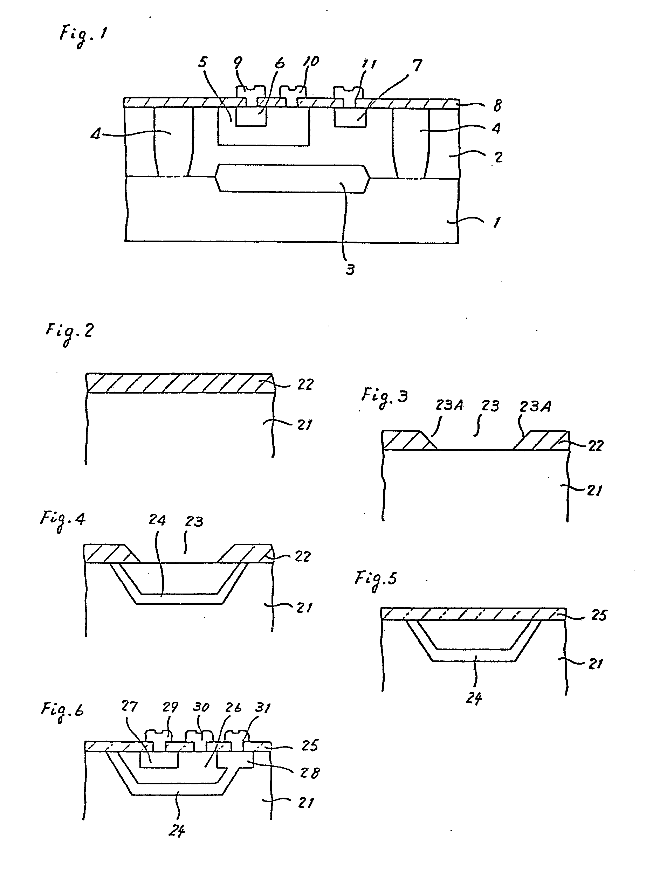

Conventionally, a transistor in a bipolar integrated circuit device has a structure as indicated in Figure 1 of the accompanying drawings which is a schematic cross-sectional diagram. In Figure 1, 1 is a P type semiconductor substrate; 2 is an N type epitaxial layer formed on the substrate 1; 3 is an $N^+$ type buried layer deposited at the boundary between substrate 1 and the epitaxial layer 2, 4 is a P type isolation region formed to extend to the substrate 1 from the surface of the epitaxial layer 2. In addition, 5 is a P type base region formed on or in the epitaxial layer 2 in a region defined within the isolation region 4 for the formation of an active element; 6 is an $N^+$ type emitter region formed within the base region 5; 7 is an $N^+$ type collector contact region formed within the epitaxial layer 2. Moreover, 8 is an insulating film covering the surface of the epitaxial layer 2; 9 is an emitter electrode; 10 is a base electrode; and 11 is a collector electrode.

In such a bipolar transistor, the collector of the transistor consists of the $N^+$ type buried layer 3 and the $N^+$ type collector contact region 7. Collector series resistance can be reduced and the operating speed characteristic can be improved (that is, operating speed can be increased) by forming buried layer 3 and the collector contact region 7 in proximity to one another and, when possible, in such a way that they contact one another.

However, in a production method for fabricating the bipolar transistor of Figure 1, the collector contact region 7 is generally formed simultaneously with the emitter region 6 and as a result it is formed with almost the same depth as the emitter region 6 and does not extend down to the buried layer 3. As a result, the epitaxial layer 2 of lower impurity concentration extends between the collector contact region 7 and the buried layer 3, so that a reduction in collector series resistance is not achieved.

It has been attempted to form the collector contact region 7 more deeply by forming the emitter region 6 and the collector contact region 7 separately, but this results in an increase in the number of fabrication steps required.

In order to overcome such difficulties of forming a collector in a conventional bipolar transistor and in the fabrication methods for such formation, the present applicant has proposed the following method in Japanese Patent Application No. 50—364 (application date: December 23rd, 1974).

That is, as indicated in Figure 2 of the accompanying drawings, which is a schematic cross-sectional view, an insulating film 22 of silicon dioxide is formed to a thickness of about 1 $\mu$m on the surface of a P type silicon semiconductor substrate 21.

Then, as illustrated in Figure 3 of the accompanying drawings, which is another schematic cross-sectional view, parts of the insulating film 22 are selectively removed by etching, thus forming a window 23 in which a part of the semiconductor substrate 21 is exposed. The edge 23A of the window 23 in the insulating film 22 is provided with a taper of an inclination of about 45° by a proper selection of etching conditions.

Thereafter, phosphorus ions ($P^+$) are implanted into the semiconductor substrate 21 using the insulating film 22 as a mask, and thereby, as illustrated in Figure 4 of the accompanying drawings, which is another schematic cross-sectional diagram, an $N^+$ type buried layer 24 is formed. The $N^+$ type buried layer 24 is flat beneath the window 23 (that is, lies at a constant depth) but is inclined and changes continuously in depth at areas just under the inclined portions of the insulating film 22 and part of the buried layer 24 extends up to the boundary between the semiconductor substrate 21 and the insulating film 22.

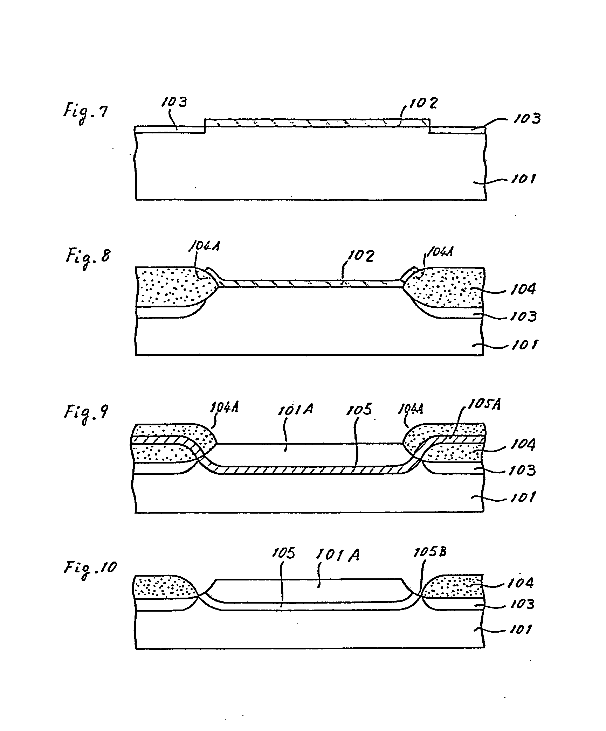

Then, the insulating film 22 is removed, and as illustrated in Figure 5 of the accompanying drawings, which is another schematic cross-sectional diagram, an insulating film 25 is newly formed on the surface of the semiconductor substrate 21.

Thereafter, a window is provided in the insulating film 25, and phosphorus ions ($P^+$) are implanted into a P type region 26 which is surrounded by the $N^+$ type layer 24 and into an exposed area of the $N^+$ type buried layer 24, and thereby, as illustrated in Figure 6 of the accompanying drawings, which is another schematic cross-sectional diagram, an $N^+$ type emitter region 27 and an $N^+$ type collector contact region 28 are formed. The P type region 26 provides a base region. In Figure 6, 29, 30 and 31 are respectively an emitter electrode, a base electrode and a collector electrode.

$N^+$ type buried layer 24 forms a collector region, and a part of that $N^+$ type buried layer is led up to the surface of the semiconductor substrate by means of only a single ion implantation step. Therefore, it is sufficient for the purposes of leading out the collector to a collector electrode, to form the collector contact region 28 to the same depth as the emitter region 27, and thereby the production process can be simplified as compared with that required for the realization of the structure illustrated in Figure 1.

However, in the method illustrated in Figures 2 to 6, it is difficult to form a tapered portion with a desired inclination at the edge 23A of the window 23 on the insulating film 22 in the process illustrated in Figure 3. That is, after providing the window 23 on the insulating film 22, a tapered portion is formed at the edge 23A of the window 23 by changing the etching solution or by changing the mask used for etching, thus making the process of forming a window 23 with a desired inclination angle and size troublesome and difficult.

Neues aus der Technik, Vo. 592, No. 3, June 15, 1978, Abstract 465 discloses the formation of an oxide film, using an oxide mask, the film having an aperture with a tapered edge. Ion implantation into a silicon body is carried out using the oxide film as a mask to form a buried region. The zone of maximum concentration of doping thus introduced follows the contour of the tapered edge.

According to the present invention there is provided a method of fabricating a semiconductor circuit device, wherein an insulating layer is formed on the surface of a semiconductor substrate and is provided with a window having a tapered edge which tapers down to the surface of the substrate, a buried layer is formed in the substrate, by ion implantation of impurities into the substrate and insulating layer using the insulating layer as a mask, in such a manner that the buried layer has a constant depth in a region of the substrate not masked by the insulating layer, turns up to the surface of the substrate in correspondence with the tapering of the edge of the window, and extends in a continuous manner into the insulating layer from the surface of the substrate, and a circuit element is formed in that part of the substrate which is above and is surrounded by the buried layer, characterised in that a part of the buried layer is exposed by removing a portion of the insulating layer which portion has suffered ion implantation of the said impurities.

An embodiment of the present invention can provide a method of fabricating an element having a buried layer, in a bipolar integrated circuit device, which facilitates the leading out of the buried layer to the surface of a semiconductor substrate in which the element is formed. The circuit element is structured in an active region which is surrounded by the buried layer.

An embodiment of the present invention can provide a method of fabrication for an element having a buried layer, in a bipolar integrated circuit device, such that integration density in the device can be improved.

The present invention can also be applied to I²L semiconductor integrated circuit devices.

Reference is made, by way of example, to the accompanying drawings, in which:—

Figure 1 is a cross-sectional diagram illustrating the structure of a conventional bipolar transistor in a bipolar integrated circuit device;

Figures 2 to 6 are respective cross-sectional diagrams for assistance in explanation of a method of producing a bipolar transistor previously proposed by the present applicant;

Figures 7 to 13 are respective cross-sectional diagrams illustrating a first process for fabricating a bipolar integrated circuit device embodying the present invention; and

Figures 14 and 15 are respective cross-sectional diagrams, and Figure 16 is a plan view, illustrating a second process for fabricating a bipolar integrated circuit device, in this case an I²L device, embodying the present invention.

Referring now to Figs. 7—13 a P type silicon (Si) substrate 101 with an impurity concentration of about $1 \times 10^{15}$ atoms/cm³ is first prepared.

Next, a silicon nitride film 102 is selectively formed on an active region of the surface of the silicon substrate 101 (e.g. on a region where a circuit element is to be formed) and a channel cut layer 103 with a concentration (of impurity) as high as $1 \times 10^{17}$ atoms/cm³ is formed at the surface of silicon substrate 101 by ion implantation of boron ions (B⁺) into the surface of the silicon substrate 101 using the silicon nitride film 102 as a mask. This is illustrated in Figure 7.

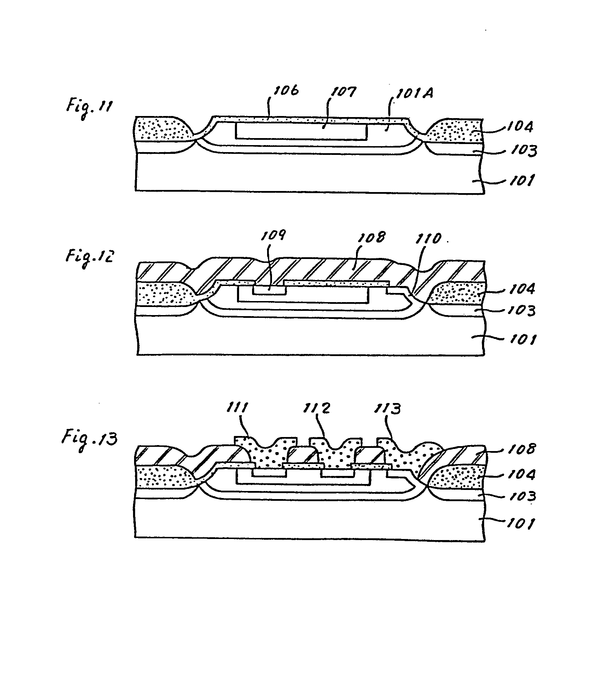

Thereafter, the surface of the silicon substrate 101 is oxidised using a selective oxidation process employing the silicon nitride film 102 as a mask and thereby a silicon dioxide film (SiO₂) layer 104 is formed to a thickness of about 1.1 $\mu$m. This is illustrated in Figure 8.

As a result of the selective oxidation process employing silicon nitride film 102 as a mask, the silicon dioxide layer 104 is formed in such a manner that a part of it progresses beneath the bottom of the silicon nitride film 102 along the boundary between the silicon nitride film 102 and the silicon substrate 101, causing the formation of a so-called "bird's beak". When the silicon nitride film 102 is removed, the exposed portion of the silicon substrate 101, namely the active region, is defined by and surrounded by the silicon dioxide layer 104 of which the edge 104A is inclined or tapered or curved.

Thereafter, phosphorus ions (P⁺) are implanted into the silicon substrate 101 using the silicon dioxide layer 104 as a mask. For example, the ion implantation conditions are as follows: acceleration energy 400 KeV, and dosage $1 \times 10^{15}$ atoms/cm². As a result, as illustrated in Figure 9, an N⁺ type buried layer of $2 \times 10^{19}$ atoms/cm³ is formed at a depth of 5000Å to 6000Å within the silicon substrate 101 where the substrate 101 is not covered by the silicon dioxide layer 104, and an ion implantation layer 105A is formed at a depth of 4000Å to 4500Å within the silicon dioxide layer 104, and the N⁺ type buried layer 105 and the ion implantation 105A come into contact with each other at the surface of the silicon substrate 101 beneath the tapered or inclined edge 104A of the silicon dioxide layer 104. Namely, the N⁺ type buried layer 105 gradually approaches or curves up to or comes up close to the surface of the silicon substrate 101, in a fashion provided by the tapering angle or curvature of edge 104A, under the tapered edge 104A of the silicon dioxide layer 104 and appears at the surface of the silicon substrate 101 under the silicon dioxide layer 104.

An active region 101A of the silicon substrate 101 surrounded by the $N^+$ type buried layer 105 is inverted to an $N^-$ type region with a surface impurity concentration of about $1 \times 10^{17}$ atoms/cm³ by such phosphorus ion implantation. Such inversion is effected because the phosphorus ions are normally distributed (Gaussian distribution) in the ion implanted region. When it is required to further increase impurity concentration of such $N^-$ type active region 101A, this can be done by further implantation of phosphorus ions into the active region 101A by reducing ion implantation energy.

Thereafter, the surface of the silicon dioxide layer 104 is removed by etching using a fluoric acid series etching solution. As a result of the phosphorus ion implantation, parts beneath the surface of the damaged silicon dioxide layer to a depth of about 4000Å to 4500Å are easily etched. In addition, as a result of such etching process, the edge 105B of the $N^+$ type buried layer 105 is exposed. This is shown in Figure 10. In the etching of the silicon dioxide layer 104, the etching speed of parts which have been subjected to ion implantation is enhanced to about twice that of parts not subjected to ion implantation. Therefore, termination of etching for parts which have been subject to ion implantation can be detected easily by observing etching speed changing points.

Thereafter, a silicon dioxide film 106 is formed to a thickness of about 2000Å by a thermal oxidation process on the surface of the active region 101A. Then a window is selectively provided on the silicon dioxide film 106 and/or boron ions are implanted using a photoresist layer (not illustrated) formed on the silicon dioxide film 106 as a mask, and thereby a P type base region 107 is formed on the active region 101A. For example, such boron ion implantation can be carried out under such condition that acceleration energy is 50 KeV and dose is $1 \times 10^{15}$ atoms/cm². As a result, the base region 107 is formed to a thickness of about 1500Å. This is shown in Figure 11.

Windows are provided in the silicon dioxide film 106 where it covers the base region 107 and where it covers exposed portion 105B of the $N^+$ type buried layer 105 and a phosphosilicate glass (PSG) layer 108 is then formed to a thickness of about 6000Å to 1 $\mu$m covering over the windows and silicon dioxide layer 104 and silicon dioxide layer 106. A well known CVD (chemical vapour deposition) method can be used for formation of PSG layer 108.

Then, phosphorus is diffused from the PSG layer 108 by heat treatment and thereby an $N^+$ type emitter region 109 and an $N^+$ type collector contact region 110 with a surface concentration of $1 \times 10^{20}$ atoms/cm³ and a depth of about 2000Å are formed.

The base region 107 reaches a depth of 3000Å because boron ions advance by diffusion. This is shown in Figure 12.

Next, windows are formed selectively on the PSG layer 108 and silicon dioxide film 106, and moreover an aluminium layer is deposited to a thickness of about 1 $\mu$m by an evaporation method covering the windows and PSG layer 108. In succession, the aluminium layer is selectively removed by etching to form an emitter electrode 111, a base electrode 112, and a collector electrode 113. This is shown in Figure 13.

In the bipolar transistor structure indicated with reference to Figures 7 to 13, $N^+$ type buried layer 105 which forms a portion for leading out the collector extends up to the surface of the semiconductor substrate at curved end parts thereof, and thereby connection to collector contact region 110 can be effected easily; as a result collector region series resistance can be made very small.

Therefore, high speed operation can be realized by the bipolar transistor structure.

In addition, since the formation of the collector contact region 110 does not require the utilization of a wider area than necessary for other steps, a bipolar transistor structured as in Figures 7 to 12 can be made small in size, thus realising higher integration density in an integrated circuit device.

According to an embodiment of the present invention described above, since the silicon dioxide layer formed by a selective oxidation process is used as a mask for obtaining a buried layer, the edge of the window provided by the mask is naturally tapered or curved. Therefore, as compared with the previous proposal of Figures 2 to 6, the fabrication processes involved in an embodiment of the present invention are much simplified as compared with the prior method wherein the edge is provided with a taper through a plurality of processing steps for the edge of a window of the mask used for forming the buried layer.

Moreover, since, in the embodiment of the present invention illustrated above, the emitter region and collector contact region are formed in the same process step, fabrication steps can be simplified.

Furthermore, according to the embodiment of the present invention described above, the buried layer is formed by an ion implantation method and circuit elements such as a transistor are formed in a part of the semiconductor substrate surrounded by the buried layer, so that an epitaxial layer forming process which is required in the prior proposal of Figure 1 is no longer necessary and thereby fabrication processes are simplified.

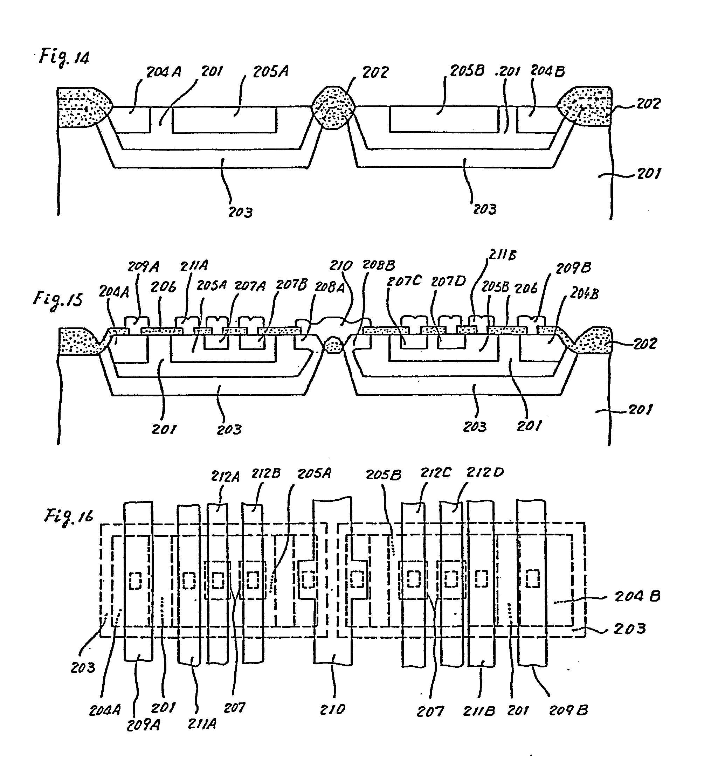

Figures 14 to 16 illustrate an integrated injection Logic ($I^2L$) device, and the fabrication of such a device, according to another embodiment of the present invention. The $I^2L$ device is formed by using similar techniques to those described above in connection with Figures 7 to 13. Thus, a buried layer (203) is formed which curves upwards towards the semiconductor substrate surface. The buried layer is formed using an oxide film (202), formed by selective oxidation, as a mask, so that curved or tapered edges of the oxide film are naturally provided.

Figure 14 shows that a silicon dioxide layer 202 having a tapered edge is grown on the surface of an N type silicon substrate 201 by a selective oxidation method and then N$^+$ type buried layers 203 are formed by phosphorus ion implantation using the silicon dioxide layer 202 as a mask.

Thereafter, P type regions 204A, 204B, 205A, 205B are formed by selective diffusion of boron or by boron ion implantation in the active regions surrounded by the N$^+$ type buried layers 203. Here, since the silicon dioxide layer 202 which is used as the mask for ion implantation is formed with a tapered edge, the N$^+$ type buried layers 203 rise to the surface of the silicon substrate 201 along the tapered edge.

The foregoing ion implantation for obtaining the buried layer 203 is performed under conditions, for example, such that acceleration energy is 400 KeV and the dosage $1 \times 10^{15}$ atoms/cm$^2$. The ion implantation for obtaining the P type regions 204, 205 is performed under conditions, for example, such that acceleration energy is 50 KeV and the dosage is $1 \times 10^{14}$ atoms/cm$^2$.

Figure 15 illustrates that, after exposing parts of the N$^+$ type buried layers 203 by removing parts of the silicon dioxide layer 202 damaged by ion implantation by etching, a silicon dioxide film 206 is formed on the surface of the active region; N type regions 207A, 207B, 207C and 207D and 208A, 208B are formed by providing windows in the silicon dioxide film 206 and by implanting arsenic ions (As$^+$) into the P type regions 205A, 205B and N type region 201; and then electrodes are formed by providing windows in the silicon dioxide film 206 and depositing a metal layer such as aluminium and selectively removing parts of the metal layer.

The ion implantation of arsenic is carried out under conditions, for example, such that acceleration energy is 80 KeV and the dosage is $5 \times 10^{15}$ atoms/cm$^2$.

Figure 16 shows a plan view of the I$^2$L device as illustrated in Figure 15.

In the structure shown in Figures 15 and 16, P type regions 204A, 204B, N type regions 201 and P type regions 205A, 205B form lateral PNP transistors within regions surrounded by the N$^+$ buried layer 203 with the P type regions 204A, 204B used as injectors and N type regions 201 as base regions.

In addition, N type regions 201, P type regions 205A and 205B and N type regions 207A, 207B, 207C and 207D form vertical NPN transistors respectively for which the N$^+$ type buried layers 203 are used as emitter lead out portions, P type regions 205A and 205B are used as base regions and N type regions 207A, 207B, 207C and 207D are used as collector regions. Electrodes 209A, 209B are respective injector electrodes and electrode 210 is used as a base electrode of lateral PNP transistors and as emitter electrodes of vertical NPN transistors. Moreover, electrodes 211A, 211B are respectively used as collector electrodes of lateral PNP transistors and as base electrodes of vertical NPN transistors. Thus, electrodes 212A to 212D form collector electrodes of the vertical NPN transistors.

In such a structure embodying the present invention, since N$^+$ type buried layers 203 extend up to the surface of the semiconductor substrate, connection between an emitter region and an emitter contact region 208 of a vertical NPN transistor can be made very easily and thereby emitter region series resistance can be kept very small.

Since an emitter region electrode is deposited at the surface of the silicon substrate 201, connection with a lead wire leading out the electrode can be easily effected.

Furthermore, since the P type injector regions 204A, 204B are surrounded by N$^+$ type buried layers 203 except for surfaces of the injector regions facing P type regions 205A, 205B, a lesser amount of carriers (holes) injected are lost and injection efficiency of the lateral PNP type transistors can be improved.

According to the embodiment of the present invention illustrated in Figures 14 to 16, since a silicon dioxide layer formed by a selective oxidation process is used as a mask for forming a buried layer 203, the required tapered portion is formed naturally at the edge of a window in the mask. For this reason the silicon dioxide layer is directly used as the mask and thereby a buried layer 203 of which the edge extends up to the surface of the silicon substrate 201 can be formed very easily.

Thus, an embodiment of the present invention provides a structure for a semiconductor integrated circuit device which includes circuit elements such as a bipolar transistor for example, in which a buried layer for the bipolar transistor is formed by an ion implantation method using an insulating layer formed with a window therein the edge of which window is tapered at the surface of a semiconductor substrate, as a mask. A part of the buried layer appears at the surface of the semiconductor substrate, thus providing for establishment of connection to electrodes. Such a circuit element is formed in an active region surrounded by the buried layer.

**Claims**

1. A method of fabricating a semiconductor circuit device, wherein an insulating layer (104) is formed on the surface of a semiconductor substrate (101) and is provided with a window having a tapered edge which tapers down to the surface of the substrate, a buried layer (105) is formed in the substrate, by ion implantation of impurities into the substrate and insulating layer using the insulating layer as a mask, in such a manner that the buried layer has a constant depth in a region of the substrate not masked by the insulating layer, turns up to the surface of the substrate in correspondence with the tapering of the edge of the window, and extends in a continuous manner into the insulating layer from the surface of the substrate, and a circuit element is formed in that part (101A) of the substrate which is above and is surrounded by the buried layer, characterised in that a part (105B) of the buried layer is exposed by removing a portion of the insulating layer which portion has suffered ion implantation of the said impurities.

2. A method as claimed in claim 1, wherein the insulating layer is formed by selective oxidation of the surface of the substrate.

3. A method as claimed in claim 1 or 2, wherein a contact region is formed at the exposed part of the buried layer.

4. A method as claimed in claim 1, 2 or 3, wherein the circuit element is a bipolar element.

5. A method as claimed in claim 1, 2 or 3, wherein the circuit element is an $I^2L$ element.

6. A method as claimed in any preceding claim, wherein the substrate is of a first conductivity type and the ion implanted impurities are of a second, opposite, conductivity type.

7. A method as claimed in claim 1, 2 or 3 wherein the semiconductor substrate is of one conductivity type and the buried layer is of the opposite conductivity type, and wherein a first region, of the said opposite conductivity type, is formed which is surrounded by the buried layer, a second region, of the said one conductivity type, is formed in the first region, a third region, of the said opposite conductivity type, is formed in the second region, and a bipolar circuit element is formed in which the buried layer is used as a lead out portion for the said first region.

8. A method as claimed in claim 1, 2 or 3, wherein the semiconductor substrate is of one conductivity type and the buried layer is of the said one conductivity type, and wherein a first region, of the said one conductivity type, is formed which is surrounded by the buried layer, second and third regions, of the opposite conductivity type, are formed separately in a lateral direction within the first region, a fourth region, of the said one conductivity type, is formed within the said first region, and an integrated injection logic element is formed in which the buried layer is used as a lead out portion for the first region.

9. A semiconductor circuit device fabricated by a method as claimed in any one of claims 1 to 8.

**Patentansprüche**

1. Verfahren zur Herstellung einer Halbleiterschaltungsvorrichtung, bei welcher eine isolierende Schicht (104) auf der Oberfläche eines Halbleitersubstrats (101) gebildet und mit einem Fenster versehen wird, welches einen gekrümmten Rand hat, der zu der Oberfläche des Substrats nach unten gekrümmt ist, eine vergrabene Schicht (105) in dem Substrat gebildet wird, durch Ionenimplantation von Verunreinigungen in das Substrat und die isolierende Schicht, welche als Maske auf solch eine Weise verwendet wird, daß die vergrabene Schicht eine konstante Tiefe in einem Bereich des Substrats hat, der nicht von der isolierenden Schicht maskiert ist, in Übereinstimmung mit der Abschrägung des Fensters sich nach oben zu der Oberfläche des Substrats wendet und sich in einer kontinuierlichen Art von der Oberfläche des Substrats in die isolierende Schicht erstreckt, und ein Schaltungselement in dem Teil (101A) des Substrats gebildet wird, welches oberhalb und von der vergrabenen Schicht umgeben ist, dadurch gekennzeichnet, daß ein Teil (105B) der vergrabenen Schicht durch Entfernen eines Teils der isolierenden Schicht, der unter der Ionenimplantation von Verunreinigungen gelitten hat, exponiert wird.

2. Verfahren nach Anspruch 1, bei welchem die isolierende Schicht durch selektive Oxidation der Oberfläche des Substrats gebildet wird.

3. Verfahren nach Anspruch 1 oder 2, bei welchem ein Kontaktbereich an dem exponierten Teil der vergrabenen Schicht gebildet wird.

4. Verfahren nach einem der Ansprüche 1, 2 oder 3, bei welchem das Schaltungselement ein bipolares Element ist.

5. Verfahren nach Anspruch 1, 2 oder 3, bei welchem das Schaltungselement ein $I^2L$-Element ist.

6. Verfahren nach einem der vorhergehenden Ansprüche, bei welchem das Substrat von einem ersten Leitfähigkeitstyp und die als Ionen implantierten Verunreinigungen von einem zweiten, entgegengesetzten Leitfähigkeitstyp sind.

7. Verfahren nach Anspruch 1, 2 oder 3, bei welchem das Halbleitersubstrat von einem Leitfähigkeitstyp und die vergrabene Schicht vom entgegengesetzten Leitfähigkeitstyp ist, und bei welchem ein erster Bereich, von dem genannten entgegengesetzten Leitfähigkeitstyp, gebildet wird, welcher von der vergrabenen Schicht umgeben ist, ein zweiter Bereich, von dem genannten einen Leitfähigkeitstyp, in dem ersten Bereich gebildet wird, ein dritter Bereich, von dem genannten entgegengesetzten Leitfähigkeitstyp, in dem zweiten Bereich gebildet wird, und ein bipolares Schaltungselement gebildet wird, in dem die vergrabene Schicht als ein nach außen leitender Abschnitt für den genannten ersten Bereich verwendet wird.

8. Verfahren nach Anspruch 1, 2 oder 3, bei welchem das Halbleitersubstrat von einem Leitfähigkeitstyp und die vergrabene Schicht von dem genannten einen Leitfähigkeitstyp ist, und bei welchem ein erster Bereich, von dem genannten einen Leitfähigkeitstyp, gebildet wird, der von der vergrabenen Schicht umgeben ist, zweite und dritte Bereiche, von dem entgegengesetzten Leitfähigkeitstyp, separat in einer seitlichen Richtung innerhalb des ersten Bereichs gebildet werden, ein vierter Bereich, von dem genannten einen Leitfähigkeitstyp, innerhalb des genannten ersten Bereichs gebildet wird, und ein integriertes Injektions-Logikelement gebildet wird, in dem die vergrabene Schicht als nach außen leitender Abschnitt für den ersten Bereich verwendet wird.

9. Halbleiterschaltvorrichtung, hergestellt nach einem Verfahren wie es in irgendeinem der Ansprüche 1 bis 8 beansprucht ist.

**Revendications**

1. Procédé de fabrication d'un dispositif à circuit semi-conducteur, dans lequel une couche isolante (104) est formée sur la surface d'un substrat semi-conducteur (101) et est prévue avec une fenêtre ayant un bord incliné, descendant vers la surface du substrat, une couche encastrée (105) étant formée dans le substrat par implantation d'ions d'impuretés dans le substrat et une couche isolante, en utilisant la couche isolante comme un masque de manière que la couche encastrée soit à une profondeur constante dans une région du substrat non masquée par la couche isolante, remontant jusqu'à la surface du substrat en correspondance avec l'inclinaison du bord de la fenêtre et s'étendant d'une manière continue dans la couche isolante depuis la surface du substrat, et un élément du circuit étant formé dans la partie (101A) du substrat qui se trouve au-dessus et qui est entourée par la couche encastrée, caractérisé en ce qu'une partie (105B) de la couche encastrée est exposée en éliminant une partie de la couche isolante, cette partie ayant subit une implantation d'ions desdites impuretés.

2. Procédé selon la revendication 1, dans lequel la couche isolante est formée par oxydation sélective de la surface du substrat.

3. Procédé selon la revendication 1 ou 2, dans lequel une région de contact est formée à la partie exposée de la couche encastrée.

4. Procédé selon la revendication 1, 2 ou 3, dans lequel l'élément de circuit est un élément bipolaire.

5. Procédé selon la revendication 1, 2, ou 3, dans lequel l'élément de circuit est un élément ($I^2L$).

6. Procédé selon l'une quelconque des revendications précédentes, dans lequel le substrat est d'un premier type de conductivité et les ions d'impuretés implantés sont d'un second type opposé de conductivité.

7. Procédé selon la revendication 1, 2 ou 3, dans lequel le substrat semi-conducteur est d'un type de conductivité et la couche encastrée est du type opposé de conductivité et dans lequel une première région dudit type opposé de conductivité est formée, entourée par la couche encastrée, une seconde région du premier type de conductivité est formée dans la première région, une troisième région dudit type opposé de conductivité est formée dans la seconde région et un élément de circuit bipolaire est formé dans lequel la couche encastrée est utilisée comme une partie de connexion pour ladite première région.

8. Procédé selon la revendication 1, 2 ou 3, dans lequel le substrat semi-conducteur est d'un premier type de conductivité et la couche encastrée est dudit premier type de conductivité et dans lequel une première région dudit premièr type de conductivité est formée, entourée par la couche encastrée, des seconde et troisième régions, du type opposé de conductivité sont formées séparément dans une direction latérale dans la première région, une quatrième région dudit premier type de conductivité étant formée dans ladite première région et un élément logique à injection intégrée étant formé, utilisant la couche encastrée comme une partie de connexion pour la première région.

9. Dispositif à circuit semiconducteur fabriqué selon la procédé revendiqué dans l'une quelconque des revendications 1 à 8.

Fig.1

5 9 6 10 11 7

8

4 4

2

1

3

Fig.2

22

21

Fig.3

23A 23 23A

22

21

Fig.4 24 23

22

21

Fig.5

25

21

24

Fig.6 27 29 30 26 31

25

28

21

24

Fig. 7

103    102    103    101

Fig. 8

104A    102    104A    104    103    101

Fig. 9

104A    101A    105    104A    105A    104    103    101

Fig. 10

105    101A    105B    104    103    101

Fig. 11

Fig. 12

Fig. 13

Fig. 14

Fig. 15

Fig. 16